# EUROPÄISCHE PATENTANMELDUNG

(11) **EP 0 998 032 A2**
(43) Veröffentlichungstag der Anmeldung: **03.05.2000**
(21) Anmeldenummer: 99121093.1
(22) Anmeldetag: 22.10.1999
(51) Int. Cl.: H03G 1/00

(54) **Verstärkereinrichtung für HF-Signale**

(30) Priorität: 26.10.1998 DE 29819009 U
(71) Anmelder: SPAUN-electronic GmbH & Co. KG, D-78224 Singen (DE)
(72) Erfinder: Müller, Klaus Dipl.-Ing., 78256 Steisslingen (DE)
(74) Vertreter: Patentanwälte Westphal, Mussgnug & Partner

(57) **Zusammenfassung**

Verstärkereinrichtung für HF-Signale mit einer Eingangsklemme (E) und einer Ausgangsklemme (A) sowie einer zwischen die Eingangsklemme (E) und Ausgangsklemme (A) geschalteten Verstärkerstufe (10), welche über eine Stelleinrichtung (12) in ihrem Verstärkungsfaktor variierbar ist, wobei parallel zur Verstärkerstufe (10) eine Bypassleitung (22) geschaltet ist, die über Umschalteinrichtungen (18, 20) anstelle der Verstärkerstufe (10) zwischen die Eingangsklemme (E) und die Ausgangsklemme (A) schaltbar ist, wobei in einer vorgegebenen Stellung der Stelleinrichtung (12) die Umschalteinrichtungen (18, 20), die Eingangsklemme (E) und Ausgangsklemme (A) an die Bypassleitung (22) geschaltet sind.

## Beschreibung

Die Erfindung betrifft eine Verstärkereinrichtung für HF-Signale, wie diese beispielsweise aus DE-U-94 19 377.0 bekannt ist. Dort sind veränderbare Dämpfungsglieder für HF-Signale oberhalb etwa 1 MHz beschrieben. Dämpfungsglieder sind lineare, reziproke Schaltungseinrichtungen zur Verringerung der Leistung eines hochfrequenten Eingangssignales. Solche Dämpfungsglieder werden insbesondere zur Verringerung des Signalpegels in HF-Signalstrecken eingesetzt. Im Idealfall sollten sollte Dämpfungsglieder allseitige Anpassung aufweisen.

Es hat sich herausgestellt, daß insbesondere bei solchen Verstärkereinrichtungen, bei denen eine Vielzahl von terestrischen Empfangssignalen neben Satellitenempfangssignalen zur Verfügung stehen, die Verstärkerstufe innerhalb der Verstärkereinrichtung oft überfordert ist. Bei einer sehr großen Anzahl von terestrischen Empfangssignalen kann es zu Überlagerungsstörungen aufgrund der vielen terestrischen Empfangssignale kommen. Solche Überlagerungsstörungen sind natürlich unerwünscht.

Hier setzt die vorliegende Erfindung an.

Der Erfindung liegt die Aufgabe zugrunde, eine Verstärkereinrichtung anzugeben, mit der in einfacher Weise die Verstärkerstufe innerhalb der Verstärkereinrichtung abgeschaltet werden kann und trotzdem noch das Empfangssignal weiterverarbeitet werden kann.

Diese Aufgabe wird durch eine Verstärkereinrichtung gelöst, bei der parallel zur Verstärkerstufe eine Bypass-Leitung geschaltet ist. Über Umschalteinrichtungen ist diese Bypass-Leitung zwischen die Eingangsklemme und Ausgangsklemme schaltbar. Erfindungsgemäß wird diese Bypass-Leitung dann an die Eingangsklemme und Ausgangsklemme der Verstärkungseinrichtung geschaltet, wenn die Stelleinrichtung eine vorgegebene Stellung einnimmt.

In einer bevorzugten Anwendung der Erfindung ist die Stelleinrichtung ein ohmsches Potentiometer. Ein Umschalten auf die Bypass-Leitung erfolgt dann, wenn das Potentiometer eine seiner Endstellungen erreicht hat. Zweckmäßigerweise ist dies dann der Fall, wenn das Potentiometer in die Richtung gedreht wird, die die geringste Verstärkung der Verstärkerstufe verursacht.

Ist beispielsweise die Verstärkerstufe der Verstärkereinrichtung durch Drehen des Potentiometers von einem Verstärkungsfaktor 0dB auf -10dB abregelbar, so wird bei einem Weiterdrehen des Potentiometers in die dem Verstärkungsgrad vermindernde Richtung in Endstellung elektronisch dafür gesorgt, daß in dieser Endstellung die Umschalteinrichtungen die Eingangsklemme und die Ausgangsklemme auf die Bypass-Leitung schalten. Wird dagegen das Potentiometer aus dieser Endstellung in Richtung zunehmender Verstärkung verdreht, schalten sofort die Umschalteinrichtungen 18, 20 um, so daß die Verstärkerstufe mit der Eingangsklemme der Ausgangsklemme der Verstärkereinrichtung in Verbindung steht.

Weiterbildungen der Erfindung sind Gegenstand der Unteransprüche.

Die Erfindung wird nachfolgend im Zusammenhang mit zwei Figuren näher erläutert. Es zeigen:
- Figur 1: ein beispielshaftes Blockschaltbild der Verstärkereinrichtung nach der Erfindung und
- Figur 2: ein detaillierteres Schaltbild der in Figur 1 dargestellten Stelleinrichtung samt Komparator und der mit der Eingangsklemme verbundenen Umschalteinrichtung.

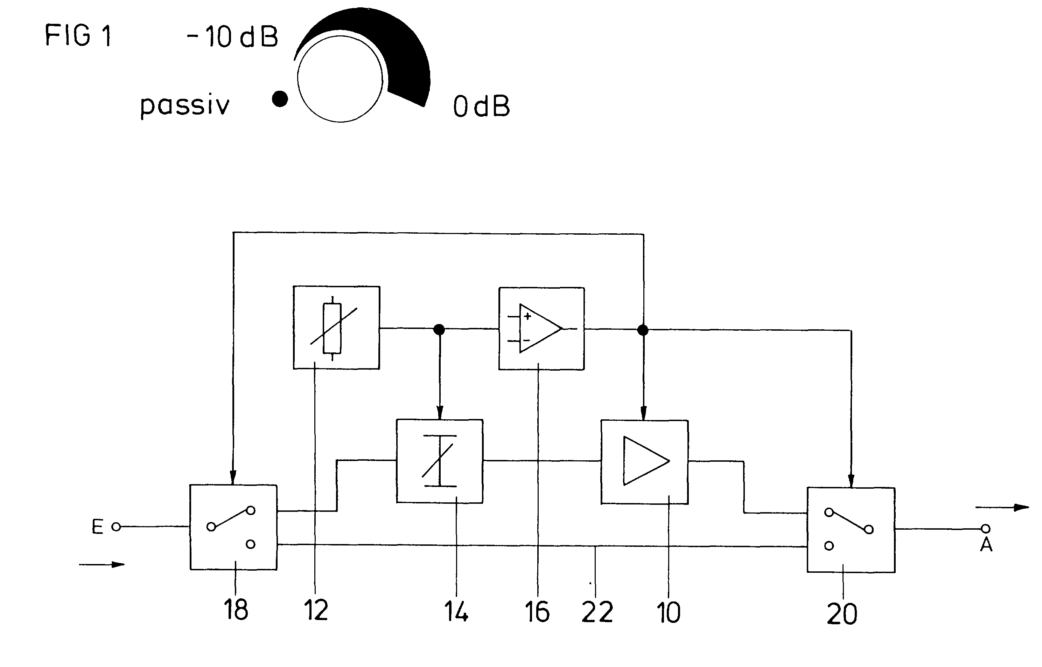

Die in Figur 1 dargestellte Verstärkereinrichtung weist eine Eingangsklemme E und eine Ausgangsklemme A auf. An die Eingangsklemme E ist eine Umschalteinrichtung 18 und an die Ausgangsklemme A eine weitere Umschalteinrichtung 20 geschaltet. In der dargestellten Schalterstellung der Umschalteinrichtungen 18, 20 sind die Eingangsklemme E über eine noch zu erläuternde Einrichtung 14 und eine Verstärkerstufe 10 mit der Ausgangsklemme A in Verbindung. Des weiteren ist eine Stelleinrichtung 12, hier andeutungsweise durch einen Potentiometer dargestellt und ein Komparator 16 vorgesehen. Die Stelleinrichtung 12 steht mit dem Komparator 16 in Verbindung und mit der bereits erwähnten Einrichtung 14. Der Komparator 16 ist ausgangsseitig mit der Verstärkerstufe 10 und mit den Umschalteinrichtungen 18, 20 in Verbindung. Der Ausgang des Komparators 16 steuert den Verstärkungsfaktor der Verstärkungsstufe 10 und das Umschalten der Umschalteinrichtungen 18, 20.

Werden die Schalter 18 und 20 in die nicht dargestellte Schalterstellung durch entsprechendes Ausgangssignal des Komparators 16 gebracht, ist die Eingangsleitung E direkt mit der Ausgangsleitung A in Verbindung. Dies wird durch eine Bypass-Leitung 22 erreicht, die zwischen die beiden Umschalteinrichtungen 18, 20 geschaltet ist.

Die Wirkungsweise der Verstärkereinrichtung von Figur 1 ist nun folgende, wenn davon ausgegangen wird, daß der Verstärkungsfaktor bzw. Dämpfungsfaktor der Verstärkerstufe 10 zwischen -10dB und 0dB durch Verdrehung der Stelleinrichtung 12 einstellbar ist. Darüber hinaus ist bei einer Endstellung der Stelleinrichtung 12 dafür gesorgt, daß die Umschalteinrichtungen 18, 20 an die Bypass-Leitung 22 geschaltet sind.

Es wird davon ausgegangen, daß die Stelleinrichtung 12 sich in Mittelstellung befindet. Diese Stellung beeinflußt lediglich den Verstärkungsfaktor bzw. Dämpfungsfaktor der Verstärkerstufe 10. Die Verstärkerstufe 10 ist beispielsweise auf -6dB Dämpfungsfaktor eingestellt. Am Ausgang des Komparators ist so ein Signal abgreifbar, daß die Umschalteinrichtungen 18, 20 in der in Figur 1 dargestellten Stellung gehalten sind. Die Stromversorgungseinrichtung 14 für die Verstärkerstufe 10 ist aktiv. An der Funktionsweise ändert sich nichts, sofern die Stelleinrichtung 12, die bevorzugt ein Drehpotentiometer ist, weiter in Richtung der Stellung gedreht wird, bei der der Verstärkungsfaktor 0db beträgt. Diese 0dB-Stellung des Potentiometers kann beispielsweise der rechte Anschlag des Potentiometers sein. Wird dagegen das Potentiometer nach links gedreht, so wird eine Stellung erreicht, bei der der minimale Verstärkungsfaktor bzw. der maximale Dämpfungsfaktor von beispielsweise -10dB erreicht ist. In dieser Stellung befinden sich die Umschalteinrichtungen 18, 20 immer noch in der in Figur 1 dargestellten Lage. Die Verstärkerstufe 10 arbeitet ebenfalls.

Wird dagegen das Potentiometer noch etwas weiter nach links in seine linke Anschlagstellung gedreht, wird einerseits die Stromversorgungseinrichtung 14 für die Verstärkerstufe 10 abgeschaltet und am Ausgang des Komparators 16 ein Signal bereitgestellt, das die Umschalteinrichtungen 18, 20 so umschaltet, daß die Eingangsklemme E direkt über die Bypass-Leitung 22 und der Ausgangsklemme A in Verbindung steht.

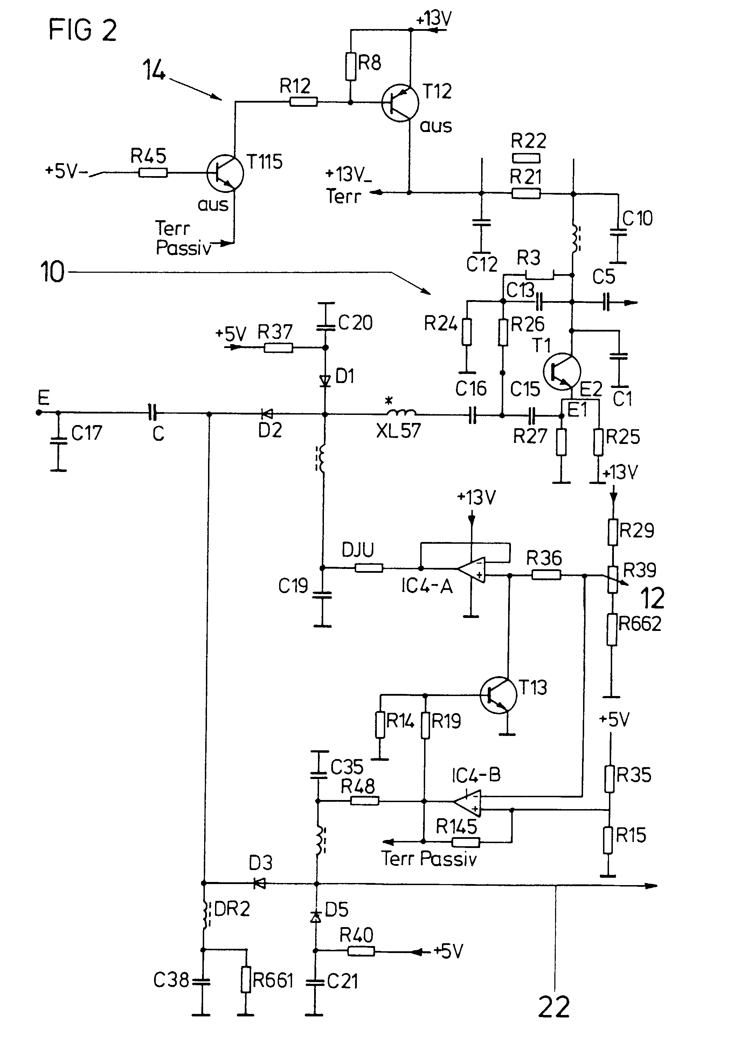

Eine detaillierte Schaltungsanordnung hierfür ist in Figur 2 dargestellt. Diese mit den einzelnen Schaltungskomponenten im Detail gezeigte Schaltungsanordnung wird jedoch nur so weit erläutert, wie dies für das Verständnis der Erfindung notwendig ist. Die Eingangsklemme E ist wiederum mit dem Bezugszeichen E bezeichnet. Das dort anstehende Eingangssignal gelangt über einen Koppelkondensator C an eine Verstärkerstufe 10, die als Pin-Dioden-Regler mit den Dioden D1 und D2 versehen ist. Die Versorgungsspannung für diesen Pin-Dioden-Regler von +13 Volt wird über den Transistor T12 der Verstärkerstufe 10 zur Verfügung gestellt. Die Basis des Transistors T12 ist über einen Widerstand R12 mit einem Transistor T115 versehen, der an seiner Basis ein fest vorgegebenes Potential von z. B. +5 Volt erhält. Der Emitter des Transistors T115 erhält dagegen ein Signal, das von dem Ausgangssignal der Stelleinrichtung 12 direkt oder indirekt abhängt. Je nachdem, ob der Transistor T115 nach Maßgabe des an seinen Emitteranschluß anstehenden Signales eingeschaltet ist oder nicht ist auch der Transistor T12 der Stromversorgungseinrichtung T14 eingeschaltet oder nicht.

Die Stelleinrichtung 12 besteht aus der Reihenschaltung von 3 Widerständen R29, R39 und R662. Diese Reihenschaltung ist zwischen +13 Volt und Bezugspotential geschaltet. Der Widerstand R39 ist als Potentiometer ausgestaltet. Dessen Mittenabgriff ist über einen Widerstand an eine Puffereinrichtung geschaltet, die ausgangsseitig über einen Widerstand R30 und eine Drossel an die Verstärkerstufe 10 geschaltet ist und zwar an dem Verbindungspunkt der beiden Dioden D1 und D2. Die mit dem Puffer verbundene Klemme des Widerstandes R36 ist an den Kollektor eines weiteren Transistors T13 geschaltet. Dessen Emitter liegt auf Bezugspotential. Der Basisanschluß ist über einen Widerstand R14 ebenfalls am Bezugspotential geschaltet. Zusätzlich ist der Basisanschluß über einen Widerstand R19 an den Ausgang eines Komparators IC4 geschaltet. Der invertierende Eingang dieses Komparators IC4 ist mit dem Mittenabgriff des Widerstandes R39 in Verbindung. Der nichtinvertierende Eingang ist mit dem Verbindungspunkt der Reihenschaltung eines Widerstandes R35 und eines Widerstandes R15 in Kontakt. Die Reihenschaltung der Widerstände R35 und R15 ist zwischen +5 Volt und Bezugspotential gelegt.

Der Komparator IC4 vergleicht durch diese Beschaltung das Spannungspotential am Abgriff des Widerstandes R39 mit dem durch die Widerstandskette der Widerstände R35 und R15 gebildete Referenzpotential. Der Ausgang des Komparators ist mit dem Emitter des Transistors T115 in Kontakt und steuert demzufolge das Ein- oder Ausschalten der Versorgungseinrichtung 14 der Verstärkerstufe 10.

Die Eingangsklemme E ist über den Koppelkondensator C nicht nur mit der Verstärkerstufe 10 in Kontakt, sondern über eine Diode D3 direkt mit der Bypass-Leitung 22.

Die Funktionsweise der Schaltung von Figur 2 ist folgende.

Solang das Potential am Mittenabgriff des Widerstandes R39 größer als das Potential am Verbindungspunkt der Widerstände R35 und R15 ist, steht am Ausgang des Komparators IC4 ein Low-Signal an, wodurch die Transistoren T115 und T12 eingeschaltet sind. Dies bedeutet, daß die Verstärkerstufe 10 mit Strom versorgt wird und arbeitet. Die Bypass-Leitung 22 wird dagegen nicht von dem Eingangssignal beaufschlagt, weil die Diode D3 sperrt. Unterscheidet dagegen das Potential am Mittelabgriff des Widerstandes R39 das Referenzpotential am nichtinvertierenden Eingang des Komparators IC4, steht am Ausgang des Komparators IC4 High-Potential an. Dies sorgt einerseits dafür, daß die Versorgungsspannung für die Verstärkerstufe 10 durch Öffnen der Transistoren T115 und T12 nicht mehr fließt und andererseits das Eingangssignal an die Bypass-Leitung 22 gelangen kann.

### Bezugszeichenliste

- 10: Verstärkerstufe
- 12: Stelleinrichtung
- 14: Stromversorgungseinrichtung
- 16: Komparator
- 18, 20: Umschalteinrichtungen
- 22: Bypass-Leitung
- A: Ausgangsklemme, Ausgangsleitung
- C: Koppelkondensator
- D1,D2,D3: Dioden
- E: Eingangsklemme, Eingangsleitung
- IC4: Komparator
- R12,R14,R15,R19,R30,R35,R36,R39,R662: Widerstand
- T12,T13,T115: Transistor
- T14: Stromversorgungseinrichtung

## Patentansprüche

1. Verstärkereinrichtung für HF-Signale mit einer Eingangsklemme (E) und einer Ausgangsklemme (A) sowie einer zwischen die Eingangsklemme (E) und Ausgangsklemme (A) geschalteten Verstärkerstufe (10), welche über eine Stelleinrichtung (12) in ihrem Verstärkungsfaktor variierbar ist,
**dadurch gekennzeichnet,**
daß parallel zur Verstärkerstufe (10) eine Bypassleitung (22) geschaltet ist, die über Umschalteinrichtungen (18, 20) anstelle der Verstärkerstufe (10) zwischen die Eingangsklemme (E) und die Ausgangsklemme (A) schaltbar ist, wobei in einer vorgegebenen Stellung der Stelleinrichtung (12) die Umschalteinrichtungen (18, 20), die Eingangsklemme (E) und Ausgangsklemme (A) an die Bypassleitung (22) geschaltet sind.

2. Verstärkereinrichtung nach Anspruch 1,
**dadurch gekennzeichnet,**
daß die Stelleinrichtung (12) ein ohmsches Potentiometer ist und die vorgegebene Stellung einer Endstellung des Potentiometers entspricht.

3. Verstärkereinrichtung nach Anspruch 1 oder 2,
**dadurch gekennzeichnet,**
daß das Potentiometer mit einem Komparator (16) verbunden ist, welcher ausgangsseitig das Umschalten der Umschalteinrichtungen (18, 20) steuert.

4. Verstärkereinrichtung nach Anspruch 2 oder 3,
**dadurch gekennzeichnet,**
daß das Potentiometer mit einer Einrichtung (14) in Verbindung steht, durch welche die Versorgungsspannung der Verstärkerstufe (10) abschaltbar ist.

5. Verstärkereinrichtung nach einem der Ansprüche 1 bis 4,
**dadurch gekennzeichnet,**
daß die Umschalteinrichtungen (18, 20) elektronische Umschalteinrichtungen sind.

6. Verstärkereinrichtung nach einem der Ansprüche 1 bis 5,
**dadurch gekennzeichnet,**
daß die Verstärkerstufe (10) ein Pin-Diodenregler ist.

7. Verstärkereinrichtung nach einem der Ansprüche 1 bis 6,
**dadurch gekennzeichnet,**
daß der Verstärkungsfaktor der Verstärkerstufe (10) einstellbar ist.

8. Verstärkereinrichtung nach einem der Ansprüche 1 bis 7,
**dadurch gekennzeichnet,**
daß die Verstärkereinrichtung zur Verstärkung von terestrischen Funksignalen vorgesehen ist.

9. Verstärkereinrichtung nach einem der Ansprüche 1 bis 8,
**dadurch gekennzeichnet,**
daß diese Bestandteil einer Satellitenempfangsanlage ist.
